(19) Europäisches Patentamt / European Patent Office / Office européen des brevets

(11) **EP 4 012 786 B1**

(12) **FASCICULE DE BREVET EUROPEEN**

(45) Date de publication et mention de la délivrance du brevet:
**12.02.2025 Bulletin 2025/07**

(21) Numéro de dépôt: **21213344.1**

(22) Date de dépôt: **09.12.2021**

(51) Classification Internationale des Brevets (IPC):
*H01L 31/0747* (2012.01)   *H01L 31/18* (2006.01)
*H01L 31/20* (2006.01)   *H01L 31/0376* (2006.01)

(52) Classification Coopérative des Brevets (CPC):
**H10F 10/166; H10F 71/10; H10F 71/103; H10F 71/128; H10F 77/1668;** Y02E 10/50; Y02P 70/50

(54) **PROCÉDÉ DE DÉTERMINATION D'UNE TEMPÉRATURE D'ÉCHAUFFEMENT D'UNE CELLULE PHOTOVOLTAÏQUE À HÉTÉROJONCTION LORS D'UN PROCÉDÉ DE TRAITEMENT**

VERFAHREN ZUR BESTIMMUNG EINER HEIZTEMPERATUR VON EINER HETEROÜBERGANGS-PHOTOVOLTAIKZELLE IN EINEM VERARBEITUNGSVERFAHREN

METHOD FOR DETERMINING A HEATING TEMPERATURE OF A HETEROJUNCTION PHOTOVOLTAIC CELL DURING A PROCESSING METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats de validation désignés:
**MA**

(30) Priorité: **11.12.2020 FR 2013089**

(43) Date de publication de la demande:
**15.06.2022 Bulletin 2022/24**

(73) Titulaire: **Commissariat à l'Energie Atomique et aux Energies Alternatives**
**75015 Paris (FR)**

(72) Inventeurs:
• **CHATELAIN, Marc**
**38054 Grenoble Cedex 09 (FR)**
• **ALBARIC, Mickaël**
**38054 Grenoble Cedex 09 (FR)**
• **KINFACK LEOGA, Arnaud**
**38054 Grenoble Cedex 09 (FR)**
• **PELLETIER, David**
**38054 Grenoble Cedex 09 (FR)**
• **VEIRMAN, Jordi**
**38054 Grenoble Cedex 09 (FR)**

(74) Mandataire: **Cabinet Camus Lebkiri**
**25 rue de Maubeuge**
**75009 Paris (FR)**

(56) Documents cités:
WO-A1-2013/001440   WO-A1-2020/082131
CN-A- 107 546 296

## Description

## DOMAINE TECHNIQUE

La présente invention concerne un procédé de traitement d'un empilement obtenu lors de la fabrication d'une cellule photovoltaïque à hétérojonction, afin d'améliorer et stabiliser le rendement de la cellule photovoltaïque.

## ÉTAT DE LA TECHNIQUE

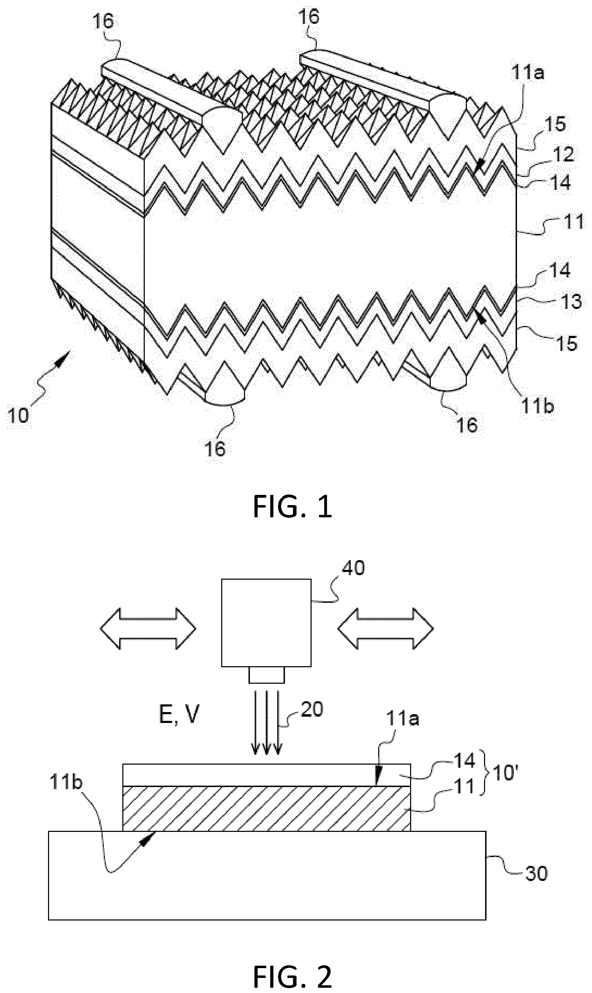

La figure 1 représente un exemple de cellule photovoltaïque 10 à hétérojonction de silicium (SHJ). La cellule photovoltaïque 10 comprend un substrat 11 en silicium cristallin dopé et deux couches de silicium amorphe 12-13 disposées de part et d'autre du substrat 11. L'une des couches de silicium amorphe 12-13 est dopée du même type de conductivité que le substrat 11, par exemple de type n, et l'autre couche est dopée du type de conductivité opposé, c'est-à-dire de type p.

L'hétérojonction est formée par le substrat 11 en silicium cristallin dopé n et la couche de silicium amorphe dopé p, cette couche formant l'émetteur de la cellule photovoltaïque. L'émetteur peut être situé en face avant ou en face arrière de la cellule photovoltaïque.

La cellule photovoltaïque SHJ est particulièrement sensible aux défauts situés à l'interface entre le substrat 11 en silicium cristallin et les couches de silicium amorphe 12-13. Ces défauts peuvent être des liaisons pendantes, également appelées « dangling bonds » en anglais, ou des impuretés telles que des ions métalliques. Ils introduisent des niveaux d'énergie dans la bande interdite du silicium et augmentent le nombre de recombinaisons électron-trou aux interfaces, ce qui détériore les paramètres de sortie de la cellule photovoltaïque, tels que la tension en circuit ouvert Voc.

Pour obtenir une cellule photovoltaïque performante, il est donc nécessaire de minimiser le nombre de recombinaisons en surface du substrat 11, ce qui est généralement accompli en déposant une couche de passivation 14 en silicium amorphe hydrogéné intrinsèque sur chacune des faces du substrat 11, avant la couche de silicium amorphe 12, 13. Les atomes d'hydrogène contenus dans les couches de passivation 14 diffusent jusqu'à la surface du substrat 11 et neutralisent les défauts.

Chacune des couches de silicium amorphe 12-13 est par ailleurs recouverte d'une couche d'oxyde transparent conducteur (ou TCO, pour « Transparent Conductive Oxyde » en anglais) 15.

Les cellules photovoltaïques SHJ sont connues pour voir leur rendement de conversion énergétique s'améliorer d'environ 0,3 % absolu sous l'action conjuguée de l'éclairement et de la température. Ce phénomène dit de bonification des cellules résulte de l'amélioration d'au moins une des couches de passivation 14 en silicium amorphe hydrogéné, ainsi que de l'amélioration des interfaces entre les couches de silicium amorphe 12-13 et les couches de TCO 15.

L'observation du phénomène de bonification des cellules photovoltaïques SHJ a conduit au développement de procédés de traitement comprenant une étape d'exposition des cellules photovoltaïques à un flux lumineux. Ces procédés sont communément appelés procédé de traitement par immersion de lumière (ou « light-soaking » en anglais).

Le document WO2013/001440 décrit un exemple de procédé de traitement de cellule photovoltaïque SHJ comprenant un substrat en silicium cristallin dopé n. Dans ce procédé de traitement, la cellule photovoltaïque est soumise à un flux lumineux d'irradiance supérieure ou égal à 500 W/m$^2$ pendant une durée d'environ 10 heures, tout en étant chauffée à une température comprise entre 20 °C et 200 °C. Une telle durée de traitement est incompatible avec la cadence des lignes de production actuelles de cellules photovoltaïques.

Les documents CN 107 546 296 A et WO 2020/082131 A1 décrivent également chacun un procédé de traitement d'un empilement de couches de cellule photovoltaïque, ledit procédé comprenant une étape d'exposition d'une face de l'empilement à un rayonnement électromagnétique émis par une source de rayonnement, et ce afin d'améliorer et stabiliser le rendement de la cellule photovoltaïque.

Il est également connu que le silicium amorphe des cellules photovoltaïques SHJ se dégrade au-delà d'une température limite, qui peut être comprise entre 190 °C et 320 °C (suivant le mode de dépôt du silicium amorphe notamment). Une telle limite de température peut être contraignante lorsque l'irradiance du flux lumineux est importante. En effet, le flux lumineux provoque un échauffement des cellules photovoltaïques SHJ à une température d'autant plus élevée que l'irradiance du flux est forte. Or il est difficile d'estimer rapidement et avec précision cette température d'échauffement. La conception d'un procédé de traitement ne risquant pas de dégrader le silicium amorphe des cellules photovoltaïques SHJ est donc longue et complexe.

## RÉSUMÉ DE L'INVENTION

Il existe donc un besoin de déterminer facilement et rapidement une température d'échauffement d'un empilement obtenu lors de la fabrication d'une cellule photovoltaïque à hétérojonction, la température d'échauffement étant atteinte lors d'un procédé de traitement de l'empilement. L'empilement comprend un substrat en silicium cristallin et une couche de passivation en silicium amorphe hydrogéné disposée sur le substrat.

Le procédé de traitement comprend une étape d'exposition d'une face de l'empilement à un rayonnement électromagnétique, le rayonnement électromagnétique étant émis par une source de rayonnement et appliqué à la face de l'empilement selon une ligne, l'empilement et la source de rayonnement étant animés d'un mouvement relatif de translation tel que la ligne balaye une partie au moins de la face de l'empilement.

On tend à satisfaire ce besoin en prévoyant un procédé de détermination de la température d'échauffement (T) comprenant les étapes suivantes :

- acquérir une pluralité de paramètres du procédé de traitement, la pluralité de paramètres comprenant une irradiance du rayonnement électromagnétique, une largeur de la ligne et une vitesse de déplacement relatif entre l'empilement et la source de rayonnement ;
- acquérir une épaisseur (e) de l'empilement ;
- calculer la température d'échauffement de l'empilement en utilisant la relation suivante :

$$V\rho c_p \frac{\Delta T_c(T)}{L_{c1}(L)} = -k\frac{\Delta T_c(T)}{\left(L_{c2}(L)\right)^2} + \phi_{source}(E,e) + \phi_{ext}$$

dans laquelle :

- V est la vitesse de déplacement relatif entre l'empilement et la source de rayonnement ;
- $\Delta T_c$ est fonction de la température d'échauffement (T) et représente une variation de température caractéristique de l'échauffement dans une direction perpendiculaire à la ligne ;
- $L_{c1}$ est fonction de la largeur de la ligne (L) et représente une première longueur caractéristique de la convection de chaleur lors du déplacement relatif entre l'empilement et la source de rayonnement ;
- $L_{c2}$ est fonction de la largeur de la ligne et représente une deuxième longueur caractéristique de la diffusion de chaleur dans une direction perpendiculaire à la ligne ;
- $\Phi_{source}$ est fonction de l'irradiance (E) du rayonnement électromagnétique et de l'épaisseur (e) de l'empilement et représente la quantité de chaleur par unité de volume apportée par la source de rayonnement ;
- $\Phi_{ext}$ représente la quantité de chaleur par unité de volume échangée avec un environnement extérieur, dans lequel est placé l'empilement lors du procédé de traitement ;
- $\rho$, $c_p$ et k sont respectivement la masse volumique, la capacité massique et la conductivité thermique de l'empilement.

Grâce au modèle analytique décrit ci-dessus, la température d'échauffement de l'empilement peut être déterminée rapidement et facilement. Le procédé de détermination peut être aisément implémenté au sein d'une chaîne de fabrication de cellules photovoltaïques à hétérojonction.

Dans un mode de mise en œuvre préférentiel du procédé de détermination, la pluralité de paramètres comprend en outre des températures relatives à l'environnement extérieur et un coefficient d'échange par convection, la quantité de chaleur par unité de volume échangée avec l'environnement extérieur étant fonction desdites températures et dudit coefficient.

Dans une variante de mise en œuvre, la quantité de chaleur par unité de volume échangée avec l'environnement extérieur est considérée comme nulle.

Un premier aspect de l'invention concerne un procédé de paramétrage du procédé de traitement de l'empilement, le procédé de paramétrage comprenant la détermination d'une pluralité de paramètres du procédé de traitement de sorte que la température d'échauffement de l'empilement atteinte lors du procédé de traitement soit inférieure ou égale à une température seuil, la pluralité de paramètres comprenant une irradiance du rayonnement électromagnétique, une largeur de la ligne et une vitesse de déplacement relatif entre l'empilement et la source de rayonnement et étant déterminée en utilisant la relation suivante :

$$V\rho c_p \frac{\Delta T_c(T)}{L_{c1}(L)} = -k\frac{\Delta T_c(T)}{\left(L_{c2}(L)\right)^2} + \phi_{source}(E,e) + \phi_{ext}$$

Dans un premier mode de mise en œuvre, le procédé de paramétrage comprend les étapes suivantes :

a) acquérir une valeur pour chacun des paramètres du procédé de traitement ;

b) acquérir une valeur d'épaisseur de l'empilement ;

c) calculer une température d'échauffement de l'empilement en utilisant ladite relation ;

d) comparer la température d'échauffement calculée à une température seuil ; et

tant que la température d'échauffement calculée est strictement supérieure à la température seuil, les étapes suivantes :

e) choisir un paramètre d'ajustement parmi les paramètres du procédé de traitement ;

f) modifier la valeur du paramètre d'ajustement ; et

g) répéter les étapes c) et d).

Dans un deuxième mode de mise en œuvre, le procédé de paramétrage comprend les étapes suivantes :

- acquérir une valeur pour chacun des paramètres du procédé de traitement ;
- acquérir une valeur d'épaisseur de l'empilement ;
- recueillir une modification de valeur d'au moins un paramètre du procédé de traitement et/ou de l'épaisseur de l'empilement ;
- sélectionner un paramètre d'ajustement parmi les autres paramètres du procédé de traitement ;
- déterminer une valeur du paramètre d'ajustement telle que la température d'échauffement de l'empilement lors du procédé de traitement soit inférieure ou égale à la température seuil, la valeur du paramètre d'ajustement étant déterminée en utilisant ladite relation.

Avantageusement, la pluralité de paramètres comprend en outre une pluralité de températures relatives à l'environnement extérieur et un coefficient d'échange par convection et le paramètre d'ajustement est choisi parmi lesdites températures et ledit coefficient.

Alternativement, le paramètre d'ajustement est choisi parmi l'irradiance du rayonnement électromagnétique, la largeur de la ligne et la vitesse de déplacement relatif entre l'empilement et la source de rayonnement.

Un deuxième aspect de l'invention concerne un procédé de traitement par balayage d'un empilement comprenant un substrat en silicium cristallin et une couche de passivation en silicium amorphe hydrogéné disposée sur le substrat, le procédé de traitement comprenant une étape d'exposition d'une face de l'empilement à un rayonnement électromagnétique émis par une source de rayonnement, le rayonnement électromagnétique étant appliqué à la face de l'empilement selon une ligne, l'empilement et la source de rayonnement étant animés d'un mouvement relatif de translation tel que la ligne balaye une partie au moins de la face de l'empilement, le procédé de traitement comprenant en outre une étape préalable de détermination d'une pluralité de paramètres à appliquer lors de l'étape d'exposition, la pluralité de paramètres comprenant une irradiance du rayonnement électromagnétique, une largeur de la ligne et une vitesse de déplacement relatif entre l'empilement et la source de rayonnement, la pluralité de paramètres étant déterminée de sorte que la température d'échauffement de l'empilement atteinte lors de l'étape d'exposition soit inférieure ou égale à une température seuil en utilisant la relation suivante :

$$V \rho c_p \frac{\Delta T_c(T)}{L_{c1}(L)} = -k \frac{\Delta T_c(T)}{\left(L_{c2}(L)\right)^2} + \phi_{source}(E, e) + \phi_{ext}$$

De préférence, la température seuil est inférieure ou égale à une température de dégradation du silicium amorphe.

Un troisième aspect de l'invention concerne un dispositif de traitement de données comprenant des moyens de mettre en œuvre un procédé de détermination selon le premier aspect de l'invention ou un procédé de paramétrage selon le deuxième aspect de l'invention.

Un quatrième aspect de l'invention concerne un produit programme d'ordinateur comprenant des instructions qui, lorsque le programme est exécuté par un ordinateur, conduisent celui-ci à mettre en œuvre un procédé de détermination selon le premier aspect de l'invention ou un procédé de paramétrage selon le deuxième aspect de l'invention.

Un cinquième aspect de l'invention concerne un support de données lisible par ordinateur, sur lequel est enregistré le produit programme d'ordinateur selon le cinquième aspect de l'invention.

## BRÈVE DESCRIPTION DES FIGURES

D'autres caractéristiques et avantages de l'invention ressortiront clairement de la description qui en est donnée ci-dessous, à titre indicatif et nullement limitatif, en référence aux figures suivantes.

[Fig. 1] est une vue schématique en perspective d'un exemple de cellule photovoltaïque à hétérojonction.

[Fig. 2] représente schématiquement un procédé de traitement d'un empilement par balayage d'une ligne de rayonnement électromagnétique selon un aspect de l'invention.

[Fig. 3] représente un mode de mise en œuvre préférentiel du procédé de traitement par balayage.

[Fig. 4] montre des résultats de calcul de la température maximale atteinte dans l'épaisseur d'un empilement pour chaque point d'une face de l'empilement, lorsque cette face est entièrement balayée par le rayonnement électromagnétique.

[Fig. 5] représente des étapes d'un procédé de détermination d'une température d'échauffement de l'empilement atteinte lors du procédé de traitement, selon un autre aspect de l'invention.

[Fig. 6] représente, en fonction de la vitesse de balayage de la ligne de rayonnement électromagnétique, des résultats de calcul obtenus par le procédé de détermination selon la figure 5 et des résultats comparatifs obtenus par simulation thermique du procédé de traitement.

[Fig. 7] représente, en fonction de l'épaisseur de l'empilement, d'autres résultats de calcul obtenus par le procédé de détermination selon la figure 5 et des résultats comparatifs obtenus par simulation thermique du procédé de traitement.

[Fig. 8] représente schématiquement un premier mode de mise en œuvre d'un procédé pour paramétrer le procédé de traitement par balayage, selon un autre aspect de l'invention.

[Fig. 9] représente schématiquement un deuxième mode de mise en œuvre du procédé pour paramétrer le procédé de traitement par balayage.

Pour plus de clarté, les éléments identiques ou similaires sont repérés par des signes de référence identiques sur l'ensemble des figures.

## DESCRIPTION DÉTAILLÉE

La figure 2 représente schématiquement un procédé de traitement d'un empilement 10' obtenu lors de la fabrication d'une cellule photovoltaïque à hétérojonction. Ce procédé de traitement vise à améliorer le rendement de la cellule photovoltaïque à hétérojonction. L'empilement 10' comprend au moins un substrat 11 en silicium cristallin (c-Si) et une première couche de passivation 14 disposée sur une première face 11a du substrat 11. L'empilement 10' peut être un précurseur de cellule photovoltaïque à hétérojonction, c'est-à-dire un produit intermédiaire obtenu au cours de la fabrication d'une cellule photovoltaïque à hétérojonction, ou une cellule photovoltaïque à hétérojonction finalisée (c.-à-d. prête à être interconnectée avec d'autres cellules photovoltaïques à hétérojonction).

Le silicium cristallin (c-Si) du substrat 11 est de préférence dopé de type n. Seules des impuretés dopantes de type donneur (par exemple des atomes de phosphore) ont été volontairement introduites dans le silicium cristallin afin de modifier sa conductivité électrique. Outre des impuretés dopantes de type donneur, le substrat 11 peut contenir, de façon non intentionnelle (et donc à l'état de traces), des impuretés dopantes de type accepteur (telles que des atomes de bore ou de gallium). La concentration en impuretés dopantes de type accepteur $N_A$ du substrat 11 est avantageusement inférieure à $10^{13}$ cm$^{-3}$, de préférence inférieure à $3.10^{12}$ cm$^{-3}$. La concentration en impuretés dopantes de type donneur $N_D$ est de préférence supérieure à 50 fois la concentration en impuretés dopantes de type accepteur $N_A$ (ou $N_D/N_A > 50$).

La première couche de passivation 14 est en silicium amorphe hydrogéné (a-Si:H). Le silicium amorphe hydrogéné de la première couche de passivation 14 est de préférence intrinsèque, c'est-à-dire non intentionnellement dopé. Le silicium amorphe hydrogéné intrinsèque permet en effet une meilleure passivation chimique des surfaces de silicium cristallin que le silicium amorphe hydrogéné dopé.

En référence à la figure 2, le procédé de traitement comprend une étape d'exposition d'une face de l'empilement 10' à un rayonnement électromagnétique 20 émis par une source de rayonnement 40. Le rayonnement électromagnétique 20 est de préférence dirigé perpendiculairement à la surface de l'empilement 10'. L'exposition au rayonnement électromagnétique 20 peut avoir lieu lorsque l'empilement 10' se trouve dans une enceinte (non représentée sur la figure 2).

L'exposition de l'empilement 10' au rayonnement électromagnétique 20 a pour effet de diminuer le nombre d'états d'interface entre le substrat cristallin 11 et la première couche de passivation 14. Autrement dit, le nombre de défauts d'interface neutralisés augmente et la qualité de la passivation s'améliore. Il en résulte une augmentation de la tension de circuit ouvert Voc et du facteur de forme (FF) de la cellule photovoltaïque, et par conséquent une augmentation de son rendement de conversion.

Le rayonnement électromagnétique 20 présente une irradiance E, appelée aussi éclairement énergétique ou densité surfacique de puissance lumineuse, qui est avantageusement supérieure ou égale à $10^3$ W/m², de préférence comprise entre $10^5$ W/m² et $5.10^6$ W/m². L'irradiance E représente la puissance du rayonnement électromagnétique reçue par une unité de surface, cette unité de surface étant orientée perpendiculairement à la direction du rayonnement électromagnétique 20.

Une telle irradiance permet de diminuer la durée d'exposition au rayonnement électromagnétique 20, aussi appelé temps de traitement t, pour un même gain en rendement (la cinétique du gain en rendement augmente avec l'irradiance du rayonnement).

Afin d'améliorer le rendement de conversion de la cellule photovoltaïque, il n'est pas obligatoire d'exposer plus d'une face de l'empilement 10' au rayonnement électromagnétique 20. De préférence, toutes les régions exposées de la face de l'empilement 10' reçoivent le rayonnement électromagnétique 20 pendant la même durée de traitement t.

La source de rayonnement 40 peut être un système laser comprenant par exemple une ou plusieurs matrices de lasers, un ensemble de diodes électroluminescentes ou tout autre dispositif capable d'émettre un rayonnement électromagnétique d'une irradiance supérieure à $10^3$ W/m².

Le rayonnement électromagnétique 20 peut être monochromatique, c'est-à-dire ne présenter qu'une seule longueur d'onde, ou polychromatique, c'est-à-dire comporter plusieurs composantes (monochromatiques) de longueurs d'ondes différentes. De préférence, le rayonnement électromagnétique 20 présente au moins une longueur d'onde comprise entre 300 nm et 1100 nm, préférentiellement entre 400 nm et 1100 nm (dans cette plage, le rayonnement est absorbé au moins en partie dans le substrat en silicium cristallin), et avantageusement entre 800 nm et 1000 nm.

La plage de longueur d'onde [800 nm-1000 nm] constitue un excellent compromis entre le flux de photons arrivant sur l'empilement 10' et la probabilité que ces photons soient absorbés par le substrat. En effet, plus la longueur d'onde est grande, moins les photons sont énergétiques et plus le flux de photons reçu par l'empilement est important à une irradiance donnée. Toutefois, la probabilité d'absorption des photons diminue fortement lorsque la longueur d'onde devient supérieure à 1000 nm. Un autre avantage à privilégier les grandes longueurs d'onde (800-1000 nm) tient au fait que les photons plus énergétiques (< 800 nm) transfèrent une partie de leur énergie sous forme de chaleur dans l'empilement, par émission de phonons. Or l'augmentation de température qui en résulte n'est pas souhaitable compte tenu du risque de dégradation du silicium amorphe.

Lors de l'étape d'exposition, aussi appelée étape d'irradiation, l'empilement 10' et la source de rayonnement 40 sont animés d'un mouvement relatif de translation (autrement dit, l'un se déplace par rapport à l'autre). Par exemple, l'empilement 10' peut être placé sur un support 30 mobile en translation et la source 40 peut être fixe. Inversement, le support 30 de l'empilement 10' peut être fixe et la source 40 mobile. L'empilement 10' et la source 40 peuvent être également tous les deux mobiles, mais pas dans la même direction et à la même vitesse.

Un tel mouvement de translation permet d'irradier une grande partie de la face de l'empilement 10' dans le cas d'une source de rayonnement 40 ayant une surface d'irradiation inférieure à la superficie de la face de l'empilement 10' (cas d'un système laser notamment). Il permet également d'irradier plusieurs empilements 10' successivement, ces empilements étant par exemple disposés sur le même support 30. Dans ce cas, il pourra être considéré que les empilements 10' défilent devant la source de rayonnement 40.

Le support 30 peut notamment être un porte-substrat ou un convoyeur capable de transporter plusieurs empilements 10' simultanément.

Le support 30 peut être en outre couplé à un système de refroidissement (non représenté), afin de diminuer la température de l'empilement 10' lors de l'étape d'exposition. Le support 30 est par exemple refroidi en faisant circuler un fluide caloporteur ou grâce à des éléments Peltier.

Outre le substrat 11 et la première couche de passivation 14, l'empilement 10' peut comprendre une deuxième couche de passivation (non représentée sur la figure 2) disposée sur une deuxième face 11b du substrat 11, opposée à la première face 11a. La deuxième couche de passivation peut être en silicium amorphe hydrogéné intrinsèque, nitrure de silicium, oxyde d'aluminium, oxyde de titane ou oxyde de silicium. A l'instar de la première couche de passivation 14, la deuxième couche de passivation contribue à réduire le nombre de recombinaisons des paires électron-trou en surface du substrat 11, augmentant ainsi le niveau d'injection dans l'empilement 10' lors de l'étape d'irradiation (et du fonctionnement ultérieur de la cellule photovoltaïque).

L'empilement 10' peut également comprendre (en présence ou non de la deuxième couche de passivation) une première couche de silicium amorphe dopé disposée sur la première couche de passivation 14, et de façon avantageuse, une couche d'oxyde transparent conducteur disposée sur la première couche de silicium amorphe dopé. Le silicium de la première couche de silicium amorphe est dopé d'un premier type de conductivité, qui peut être identique à celui du substrat 11 (par exemple de type n dans le cas d'un substrat 11 en silicium dopé de type n) ou au contraire opposé à celui du substrat 11 (ex. de type p). L'exposition au rayonnement électromagnétique 20 a alors pour effet supplémentaire d'améliorer la qualité de l'interface entre la première couche de passivation et la première couche de silicium amorphe dopé et/ou de l'interface entre la première couche de silicium amorphe dopé et la couche d'oxyde transparent conducteur.

L'empilement 10' peut également comprendre une deuxième couche de silicium amorphe dopé disposée sur la deuxième couche de passivation. Le silicium de la deuxième couche de silicium amorphe est dopé d'un deuxième type de conductivité opposé au premier type de conductivité. L'exposition au rayonnement électromagnétique 20 a alors pour effet supplémentaire d'améliorer la qualité de l'interface entre la deuxième couche de passivation et la deuxième couche de silicium amorphe dopé.

Dans un mode de mise en œuvre du procédé de traitement, l'empilement 10' est du type représenté sur la figure 1 et comprend :

- un substrat 11 en silicium cristallin, de préférence dopé n ;
- une première couche de passivation 14 en silicium amorphe hydrogéné (et de préférence intrinsèque) disposée sur la première face 11a du substrat 11 ;
- une première couche de silicium amorphe 12, disposée sur la première couche de passivation 14 et dopée d'un premier type de conductivité ;
- une première couche d'oxyde transparent conducteur 15 disposée sur la première couche dopée de silicium amorphe 12 ;
- une deuxième couche de passivation 14 en silicium amorphe hydrogéné (et de préférence intrinsèque) disposée sur la deuxième face 11b du substrat 11 ;
- une deuxième couche de silicium amorphe 13, disposée sur la deuxième couche de passivation 14 et dopée d'un deuxième type de conductivité opposé au premier type de conductivité ; et
- une deuxième couche d'oxyde transparent conducteur 15 disposée sur la deuxième couche dopée de silicium amorphe 13.

Un tel empilement ou précurseur de cellule photovoltaïque à hétérojonction est qualifié d'asymétrique en raison des deux couches de silicium amorphe 12-13 dopées de types de conductivité opposés et disposées de part et d'autre du substrat 11. Le silicium amorphe de la première couche dopée 12 et/ou de la deuxième couche dopée 13 est de préférence hydrogéné.

Lorsqu'un empilement du type de la figure 1 est exposé au rayonnement électromagnétique 20, une diminution de la résistance série de la cellule photovoltaïque est en outre observée.

Quel que soit l'empilement utilisé, la première face 11a du substrat 11 (recouverte de la première couche de passivation 14) peut être tournée vers la source de rayonnement 40, comme cela illustré par la figure 2. Alternativement, la deuxième face 11b du substrat 11 peut être tournée vers la source de rayonnement 40.

Ainsi, le procédé de traitement par balayage peut être accompli à différents stades de la fabrication d'une cellule photovoltaïque à hétérojonction. Cette cellule photovoltaïque peut être une cellule monofaciale ou bifaciale. Dans une cellule monofaciale, seule la face avant capte le rayonnement solaire. Dans une cellule bifaciale, les faces avant et arrière captent chacune une partie du rayonnement solaire. La face avant capte le rayonnement incident (i.e. direct) tandis que la face arrière capte le rayonnement diffus ou réfléchi. La face avant d'une cellule bifaciale est celle permettant d'obtenir le maximum de courant électrique lorsqu'elle est tournée vers le rayonnement incident. L'émetteur de la cellule photovoltaïque, c'est-dire la couche de silicium amorphe dopé du type de conductivité opposé à celui du substrat 11, peut être situé en face avant ou en face arrière de la cellule.

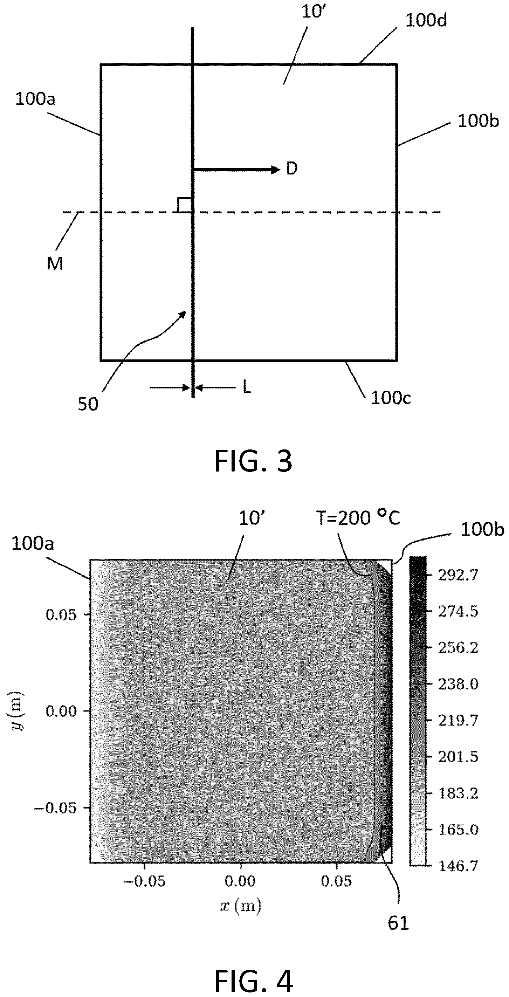

La figure 3 est une vue de dessus de l'empilement 10', prise lors de l'étape d'exposition.

La face exposée de l'empilement 10' comprend :

- un premier bord 100a appelé bord d'attaque, défini comme étant le bord à passer en premier devant la source de rayonnement 40 ;
- un deuxième bord 100b appelé bord de fuite, opposé au premier bord 100a et défini comme étant le bord à passer en dernier devant la source de rayonnement 40 ; et
- des troisième et quatrième bords 100c-100d dits transversaux (bords inférieur et supérieur sur la figure) qui relient les premier et deuxième bords 100a-100b.

La face exposée de l'empilement 10' présente de préférence une forme carrée, pseudo-carrée (angles tronqués) ou rectangulaire. Le bord d'attaque 100a et le bord de fuite 100b sont ainsi parallèles entre eux, tout comme les bords transversaux 100c-100d.

La source de rayonnement 40 est configurée de sorte que le rayonnement électromagnétique 20 soit appliqué à la face de l'empilement 10' selon une ligne 50. Autrement dit, la surface de l'empilement 10' irradiée par la source de rayonnement 40 (appelée surface d'irradiation) à un instant donné du procédé de traitement est en forme de ligne. La ligne 50 présente une largeur L qui peut être comprise entre $10^{-4}$ m et $10^{-1}$ m, de préférence entre $10^{-3}$ m et $10^{-2}$ m.

La direction D du déplacement relatif entre l'empilement 10' et la source de rayonnement 40 est telle que la ligne 50 balaye une partie au moins de la face de l'empilement 10' lors du procédé de traitement, en commençant par le bord d'attaque 100a puis en se dirigeant vers le bord de fuite 100b. La partie exposée au rayonnement électromagnétique occupe avantageusement plus de 60 % de la face de l'empilement 10', et de préférence plus de 80 %.

La direction de déplacement D de la source de rayonnement 40 par rapport à l'empilement 10', aussi appelée direction de balayage D, est par exemple perpendiculaire au bord d'attaque 100a et au bord de fuite 100b, comme cela est représenté sur la figure 3.

La ligne 50 comprend de préférence un segment de droite orienté perpendiculairement à une médiane M de la face exposée de l'empilement 10'. La médiane M est le segment de droite qui relie les milieux du bord d'attaque 100a et du bord de fuite 100b. Elle est de préférence perpendiculaire au bord d'attaque 100a et au bord de fuite 100b. La source de rayonnement 40 est avantageusement configurée pour que la ligne 50 irradie toute la largeur de l'empilement 10'.

La ligne 50 est ainsi l'intersection d'un faisceau d'ondes électromagnétiques généré par la source de rayonnement 40 avec la surface de l'empilement 10', les rayons du faisceau étant contenus dans un plan.

La vitesse V du déplacement relatif entre l'empilement 10' et la source de rayonnement 40 est de préférence choisie de façon à traiter un empilement 10' par balayage du rayonnement électromagnétique en un temps t court, typiquement compris entre 0,1 s et 30 s. La vitesse de déplacement V est avantageusement comprise entre 0,01 m/s et 1 m/s, et de préférence supérieure ou égale à 0,02 m/s.

Ce traitement par balayage est simple et rapide à mettre en œuvre. En faisant défiler en continu les empilements 10' (précurseurs de cellule photovoltaïque ou cellules photovoltaïques) devant la source de rayonnement 40, le procédé de traitement peut être accompli à une cadence élevée, compatible avec les exigences de production industrielle des cellules photovoltaïques.

A titre d'exemple, en considérant une vitesse de déplacement V comprise entre 0,01 m/s et 1 m/s et des empilements 10' dont les faces principales mesurent 156 mm par 156 mm, le temps de traitement t d'un empilement 10' est compris entre 0,156 s et 15,6 s. Le nombre d'empilements 10' traités par heure peut être compris entre 200 et 25000.

Comparé à une irradiation (simultanée) de toute la face de l'empilement, le balayage présente l'avantage de limiter l'échauffement de l'empilement au-delà d'une température de dégradation du silicium (en choisissant convenablement l'irradiance E et la vitesse de déplacement V), et dans certaines conditions de le supprimer totalement. Ainsi, la dégradation du silicium amorphe de la première couche de passivation 14 est évitée ou limitée à une faible portion dite surchauffée de l'empilement. Il n'est alors pas obligatoire de procéder à un refroidissement de l'empilement 10', par exemple au moyen d'un système de refroidissement ou lors d'une interruption de l'exposition. De préférence, la portion surchauffée occupe moins de 40 % de la face exposée de l'empilement 10', et de préférence moins de 20 %.

La température de dégradation du silicium amorphe, appelée ci-après température limite (ou critique) $T_{max}$, peut être comprise entre 190 °C et 320 °C, suivant le mode de dépôt du silicium amorphe. Elle est par exemple sensiblement égale à 200 °C. Par « sensiblement égale à 200 °C, on entend 200 °C à 5 % près (200 °C $\pm$ 5 %).

Le procédé de traitement par balayage, tel que décrit en relation avec les figures 2 et 3, peut être caractérisé par les paramètres suivants :

- E : l'irradiance du rayonnement électromagnétique 20 (en W/m$^2$) ;
- V : la vitesse de déplacement relatif entre l'empilement 10' et la source de rayonnement 40, aussi appelée vitesse de balayage du rayonnement électromagnétique (en m/s) ;
- L : la largeur de la ligne 50 (en m).

La densité surfacique d'énergie Q (en J/m$^2$), ou énergie surfacique, reçue en tout point de la face de l'empilement par rayonnement électromagnétique est définie par la relation suivante :

[Math. 1]

$$Q = (E * L)/V$$

Les paramètres E, V et L sont de préférence choisis pour obtenir une densité surfacique d'énergie Q comprise entre 10$^3$ J/m$^2$ et 10$^6$ J/m$^2$, avantageusement entre 10$^4$ J/m$^2$ et 10$^5$ J/m$^2$. Les plages de valeurs données ci-dessus pour l'irradiance E du rayonnement électromagnétique 20, la vitesse de balayage V et la largeur L de la ligne 50 sont suffisamment larges pour y parvenir.

Des simulations thermiques ont montré que les températures en différents points de l'empilement lors de l'étape d'exposition augmentent avec la densité surfacique d'énergie Q. Par ailleurs, pour une combinaison des paramètres E, V et L donnée, d'autres simulations thermiques ont montré que ces températures dépendent de l'épaisseur e de l'empilement. Plus l'épaisseur e de l'empilement est faible et plus les températures sont élevées, car la densité volumique d'énergie absorbée augmente. Tous les résultats de simulation présentés ci-après ont été obtenus avec une épaisseur d'empilement e égale à 160 μm.

La figure 4 est une cartographie de la température maximale atteinte dans l'épaisseur d'un empilement 10' (dont les faces principales sont pseudo-carrées : 156 mm x 156 mm) au cours d'un procédé de traitement selon la figure 3. Elle a été obtenue au moyen d'une simulation thermique (par volumes finis) du procédé de traitement par balayage. Dans cette simulation, la ligne 50 balaye toute la superficie de la face de l'empilement. L'irradiance E du rayonnement électromagnétique est égale à 216 kW/m$^2$, la vitesse de balayage V est égale à 2,48 cm/s et la largeur de la ligne 50 est égale à 6 mm. La courbe isotherme T = 200 °C est représentée en traits pointillés.

Cette cartographie montre que la température maximale de l'empilement au cours du traitement est la plus faible à proximité du bord d'attaque 100a (exposé en premier au rayonnement électromagnétique 20), qu'elle augmente progressivement en se dirigeant vers le bord de fuite 100b pour atteindre (et se maintenir à) une température dite de plateau de l'ordre de 195 °C, puis augmente encore pour dépasser 200 °C dans une portion 61 adjacente au bord de fuite 100b de l'empilement (c.-à-d. le bord exposé en dernier au rayonnement électromagnétique 20). En dehors de cette portion 61 surchauffée (la température limite $T_{max}$ considérée ici est égale à 200 °C), la température maximale de l'empilement 10' est donc inférieure à 200 °C.

La surchauffe locale près du bord de fuite 100b s'explique par la formation d'une couche limite thermique à l'avant du faisceau. Cette couche limite thermique est liée à la diffusion de chaleur et se propage dans l'empilement depuis le bord d'attaque 100a jusqu'au bord de fuite 100b. A l'approche du bord de fuite 100b, la chaleur ne peut plus se diffuser vers l'avant du faisceau, ce qui provoque la surchauffe.

Afin de limiter la dégradation du silicium amorphe et la diminution des performances de la cellule photovoltaïque qui en résulte, l'exposition de la face de l'empilement 10 au rayonnement électromagnétique peut également être interrompue avant que la ligne 50 n'atteigne le bord de fuite 100b de la face de l'empilement (la portion surchauffée est alors réduite ou évitée). La face de l'empilement 10' peut cesser d'être irradiée à l'approche du bord de fuite 100b soit en arrêtant la source de rayonnement 40 (et donc l'émission du rayonnement électromagnétique 20), soit en bloquant le rayonnement électromagnétique 20 émis en continu (c'est-à-dire en l'empêchant d'atteindre l'empilement), par exemple au moyen d'un obturateur.

La figure 4 montre également que la température de l'empilement est égale à la température de plateau dans une majeure partie de l'empilement, cette partie étant qualifiée de « centrale » car disposée entre le bord d'attaque 100a et le bord de fuite 100b et contenant le point situé au centre de la face exposée, en (x,y)=(0,0). On appelle ci-après « température d'échauffement T » la température de plateau atteinte par l'empilement dans cette partie centrale (notamment au centre) lors du procédé de traitement.

La mise au point d'un procédé de traitement par balayage, par exemple au sein d'une chaîne de fabrication de cellules photovoltaïques à hétérojonction, requiert la détermination d'une valeur pour chacun des paramètres E, V et L du procédé de traitement. La détermination de ces paramètres peut s'avérer délicate, car la plage de fonctionnement permettant à la fois d'obtenir le gain en rendement visé et une température acceptable est restreinte.

Afin de s'assurer (par exemple lors de la conception du procédé de traitement par balayage) que la température d'échauffement T (ou température de plateau) ne dépassera pas la température limite $T_{max}$, un procédé de détermination de la température d'échauffement T à partir des paramètres du procédé de traitement a été développé.

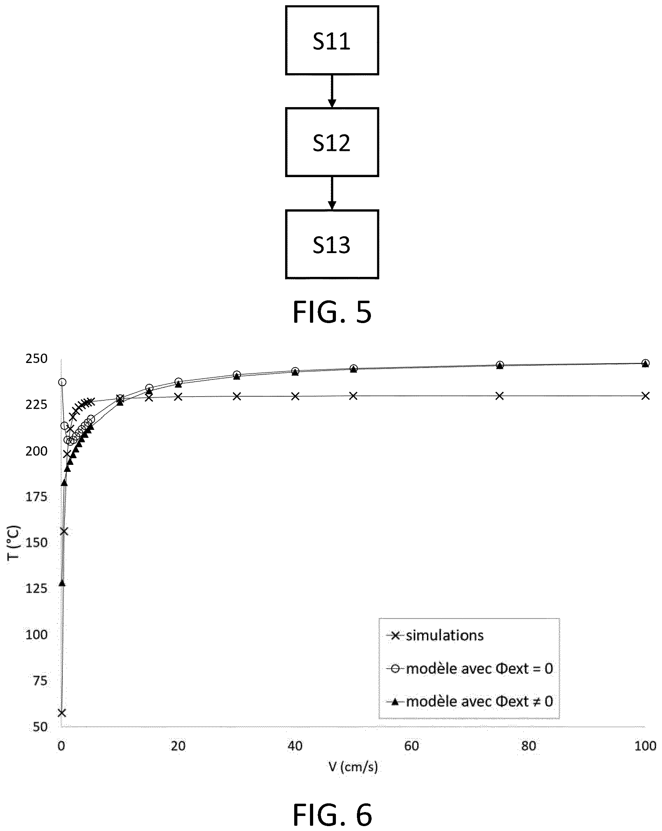

La figure 5 représente des étapes S11 à S13 de ce procédé de détermination de la température d'échauffement T. Ces étapes sont de préférence codées sous la forme d'un programme et mises en œuvre par un ordinateur (par l'exécution du programme).

Le procédé de détermination comprend tout d'abord une étape S11 d'acquisition des paramètres du procédé de traitement et une étape S12 d'acquisition d'un paramètre de l'empilement 10' (ou des empilements) à traiter, son épaisseur e. Par « acquisition » d'un paramètre, on entend la mesure (au moyen d'un capteur relié à l'ordinateur), la saisie (par un opérateur, typiquement au moyen d'un clavier) ou la récupération (typiquement dans une mémoire) d'une valeur de ce paramètre. Par exemple, l'épaisseur e de l'empilement 10' peut être mesurée par un capteur de type jauge sans contact (« Contactless Wafer Thickness Gauge ») ou déterminée via la mesure de la masse de l'empilement 10' (la masse volumique et les autres dimensions de l'empilement 10' étant connues).

Les paramètres du procédé de traitement acquis à l'étape S11 comprennent au minimum l'irradiance E du rayonnement électromagnétique 20, la vitesse de balayage V et la largeur L de la ligne 50. Les valeurs des paramètres E, V, L et e sont de préférence enregistrées dans une mémoire de l'ordinateur. Les étapes d'acquisition peuvent être accomplies dans n'importe quel ordre.

Le procédé de détermination comprend ensuite une étape S13 de calcul de la température d'échauffement T, à partir des valeurs de paramètre acquises aux étapes S11-S12. Cette étape de calcul S13 est de préférence accomplie par le processeur de l'ordinateur.

Le calcul de la température d'échauffement T repose sur un modèle analytique construit à partir de l'équation de conservation de la chaleur. En partant de l'hypothèse que la vitesse de balayage V est suffisamment élevée pour établir un régime quasi-permanent, l'équation de conservation de la chaleur au niveau de la zone irradiée de l'empilement s'écrit de la façon suivante :

[Math. 2]

$$V\rho c_p \frac{\partial T}{\partial x} = -k \frac{\partial^2 T}{\partial x^2} + \phi_{source}(E,e) + \phi_{ext}$$

où :

- V (en m/s) est la vitesse de balayage de la ligne 50 ;
- $\Phi_{source}$ (en W/m$^3$) représente la quantité de chaleur par unité de volume apportée par la source de rayonnement 40, cette quantité de chaleur étant fonction de l'irradiance E du rayonnement électromagnétique 20 et de l'épaisseur e de l'empilement 10' (en m) ;
- $\Phi_{ext}$ (en W/m$^3$) représente la quantité de chaleur par unité de volume échangée avec l'environnement extérieur dans lequel est placé l'empilement 10' lors du procédé de traitement ;
- $\rho$ (en kg/m$^3$), $c_p$ (en J/kg/K) et k (en W/m/K) sont respectivement la masse volumique, la capacité massique et la conductivité thermique de l'empilement 10' et supposées égales à celles du silicium.

Une analyse d'ordre de grandeur permet de simplifier l'équation de conservation de la chaleur de la façon suivante :

[Math. 3]

$$V\rho c_p \frac{\Delta T_c(T)}{L_{c1}(L)} = -k \frac{\Delta T_c(T)}{\left(L_{c2}(L)\right)^2} + \phi_{source}(E,e) + \phi_{ext}$$

Dans l'équation simplifiée [Math. 3] ci-dessus,

- $\Delta T_c$ (en K) représente une variation de température caractéristique de l'échauffement dans une direction perpendiculaire à la ligne 50 ;
- $L_{c1}$ (en m) représente une première longueur caractéristique de la convection de chaleur lors du déplacement relatif entre l'empilement 10' et la source de rayonnement 40 ; et
- $L_{c2}$ (en m) représente une deuxième longueur caractéristique de la diffusion de chaleur dans une direction perpendiculaire à la ligne 50.

La variation de température $\Delta T_c$ est fonction de la température d'échauffement T, tandis que les première et deuxième longueurs $L_{c1}$ et $L_{c2}$ sont fonctions de la largeur L de la ligne 50. Ces trois grandeurs caractéristiques, ainsi que les quantités de chaleur $\Phi_{source}$ et $\Phi_{ext}$, peuvent être exprimées de différentes façons, suivant les configurations de procédé de traitement, l'analyse d'ordre de grandeur réalisée et les phénomènes physiques considérés.

Dans un mode de mise en œuvre préférentiel du procédé de détermination, les grandeurs $\Delta T_c$, $L_{c1}$, $L_{c2}$, $\Phi_{source}$ et $\Phi_{ext}$ sont exprimées comme suit :

[Math. 4]

$$\Delta T_c = T - T_0$$

où $T_0$ (en K) est la température initiale de l'empilement 10', autrement dit avant que l'empilement 10' ne soit exposé au rayonnement électromagnétique 20. La température initiale $T_0$ est alors un autre paramètre du procédé de traitement qui peut être prédéterminé ou, de façon plus avantageuse, acquis lors de l'étape S11 (en même temps que E, V et L), par exemple au moyen d'un capteur de température.

[Math. 5]

$$L_{c1} = L$$

[Math. 6]

$$L_{c2} = L + \delta$$

où $\delta$ est la longueur caractéristique de la couche limite thermique à l'avant du faisceau, qui peut être approximée par :

[Math. 7]

$$\delta = \frac{k}{V \rho c_p}$$

[Math. 8]

$$\phi_{source} = \frac{E}{e}$$

La quantité de chaleur $\Phi_{ext}$ échangée avec l'environnement extérieur peut être considéré comme nulle en première approche, notamment lorsque les échanges se font par convection naturelle, pour des coefficients h < 10 W/m/K, et lorsque la vitesse de balayage V est élevée (typiquement supérieure à 0,2 m/s).

A l'inverse, le terme $\Phi_{ext}$ peut être considéré comme non nul. Il peut être alors supposé égal à la somme du flux échangé par convection $\Phi_c$ et du flux échangé par rayonnement $\Phi_r$ :

[Math. 9]

$$\phi_{ext} = \phi_c + \phi_r = \frac{2h(T - T_c)}{e} + \frac{2\varepsilon\sigma(T^4 - T_r^4)}{e}$$

où :

- h est un coefficient d'échange convectif, par exemple égal à 10 W/m$^2$/K ;
- a est la constante de Boltzmann (en W/m$^2$/K$^4$) ;
- $\varepsilon$ est l'émissivité du matériau considéré, ici le silicium (sans unité, 0<$\varepsilon$<1) ;
- $T_r$ est la température des surfaces avec laquelle l'empilement 10' échange par rayonnement, typiquement la température des parois de l'enceinte dans laquelle l'empilement est exposé au rayonnement ;
- $T_c$ est la température du fluide (typiquement de l'air) qui entoure l'empilement 10' et avec lequel il échange par convection.

Dans la relation [Math. 9], un coefficient 2 a été introduit dans les expressions des flux $\Phi_c$ et $\Phi_r$ car il est supposé que les deux faces de l'empilement échangent de la même manière avec l'environnement.

Le terme $\varphi_{ext}$ peut également inclure un terme lié au système de refroidissement et dont la formulation mathématique dépend du type de refroidissement utilisé. Par exemple, lorsque l'empilement est placé sur un support régulé en température, le terme supplémentaire pourra être un terme de diffusion à l'échelle de l'épaisseur de l'empilement, de la forme :

[Math. 10]

$$\phi_{dif} = \frac{k(T - T_{support})}{e}$$

où $T_{support}$ est la température du support.

Ce terme devient significatif dès que le temps caractéristique de diffusion à l'échelle de l'épaisseur de l'empilement, $\tau_{dif} = e^2(\rho c_p/k)$, est d'un ordre de grandeur inférieur ou égal au temps caractéristique du procédé de traitement $\tau_p = L/V$. Ce terme peut également être pondéré par une résistance thermique de contact entre l'empilement et son support.

Ainsi, lorsqu'on souhaite prendre en considération la quantité de chaleur $\Phi_{ext}$ échangée avec l'environnement extérieur, celle-ci est avantageusement déterminée à partir des températures $T_r$, $T_c$ relatives à cet environnement et du coefficient d'échange convectif h. Une valeur pour chacun de ces paramètres est avantageusement acquise lors de l'étape S11. Les températures $T_r$ et $T_c$ peuvent être mesurées au moyen de capteurs de température, tandis que le coefficient h peut être renseigné par l'opérateur ou calculé par l'ordinateur sur la base de la température $T_c$ et de relations connues.

Afin de déterminer la température d'échauffement T, l'équation [Math. 3] peut être résolue analytiquement ou numériquement à l'aide d'une méthode itérative.

Du fait qu'il repose sur un modèle analytique, le procédé de détermination de la température d'échauffement T permet d'estimer rapidement et simplement la température d'échauffement que peut atteindre l'empilement lors de son traitement par balayage. Il peut être aisément implémenté dans un équipement au sein d'une chaîne de production de cellules photovoltaïques à hétérojonction.

La figure 6 représente des résultats de calcul de la température d'échauffement T obtenus grâce au modèle analytique décrit ci-dessus et, à titre de comparaison, des résultats de simulations thermiques (par volumes finis). Les résultats de calculs sont donnés avec et sans prise en compte de la quantité de chaleur $\Phi_{ext}$ échangée avec l'environnement extérieur (relation [Math. 9]). Les valeurs de paramètres sont les suivantes : une densité surfacique d'énergie Q égale à 60 kJ/m², une irradiance E variable entre 10 kW/m² et 10000 kW/m², une vitesse de balayage V variable entre 0,1 cm/s et 1 m/s, une largeur de ligne L égale à 6 mm, une épaisseur e d'empilement égale à 160 $\mu$m, des températures $T_0$, $T_r$, $T_c$ égales à 25 °C et un coefficient de convection h égal à 10 W/m²/K. La température d'échauffement T est représentée en fonction de la vitesse de balayage V.

On constate que les valeurs de température calculées avec le modèle analytique sont proches des valeurs de température simulées. L'écart relatif entre la température d'échauffement T calculée grâce au modèle (avec $\Phi_{ext}$ = 0) et la température d'échauffement T simulée est inférieur à 17 % lorsque la vitesse de balayage V est supérieure à 1 cm/s. On constate en outre que la quantité de chaleur $\Phi_{ext}$ échangée avec l'environnement extérieur n'a pratiquement plus d'influence à partir d'une vitesse de balayage supérieure à 20 cm/s environ. Néanmoins, pour d'autres configurations (températures $T_r$, $T_c$ plus faibles, coefficient d'échange convectif h plus élevée, ajout d'un terme lié au support régulé en température...), ce terme $\Phi_{ext}$ peut avoir une influence significative sur la température d'échauffement T calculée même à des vitesses de balayage élevées.

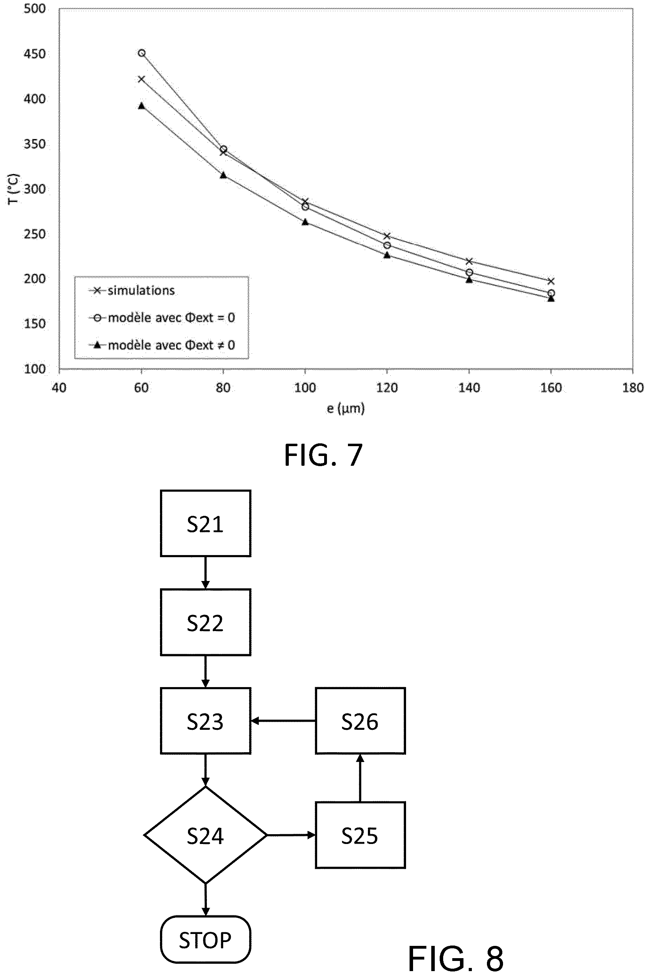

La figure 7 représente d'autres résultats de calcul et de simulations thermiques de la température d'échauffement T, cette fois en fonction de l'épaisseur e de l'empilement. Les valeurs de paramètres sont les suivantes : une densité surfacique d'énergie Q égale à 52,3 kJ/m², une irradiance E égale à 216 kW/m², une vitesse de balayage V égale à 2,48 cm/s, une largeur de la ligne 50 égale à 6 mm, une épaisseur e d'empilement variable entre 60 $\mu$m et 160 $\mu$m, des températures $T_0$, $T_r$, $T_c$ égales à 25 °C et un coefficient de convection h égal à 10 W/m²/K.

A nouveau, on constate que les valeurs de température calculées avec le modèle analytique sont proches des valeurs de température simulées.

Le procédé de détermination de la température d'échauffement T est donc précis.

Le modèle analytique décrit ci-dessus et représenté par l'équation [Math. 3] peut être également utilisé afin de déterminer un ou plusieurs paramètres du procédé de traitement, connaissant l'épaisseur e de l'empilement 10' à traiter et la température de dégradation du silicium amorphe $T_{max}$ (ou une autre température seuil, comme décrit ultérieurement).

Cette autre utilisation du modèle analytique correspond à un procédé de paramétrage du procédé de traitement par balayage (autrement dit, à un procédé pour déterminer des paramètres du procédé de traitement).

D'une manière générale, le procédé de paramétrage du procédé de traitement par balayage comprend la détermination d'un jeu de paramètres (comprenant l'irradiance E, la vitesse V et la largeur L, ainsi que, le cas échéant, la température initiale $T_0$, les températures $T_r$, $T_c$ relatives à l'environnement et le coefficient de convection h) tel que la température d'échauffement T de l'empilement lors du procédé de traitement soit inférieure ou égale à la température limite $T_{max}$. Ce jeu de paramètres est obtenu en résolvant l'équation [Math. 3]. Un ou plusieurs de ces paramètres peuvent être fixés suivant des considérations autres que la température, notamment le temps de traitement d'un empilement, l'amélioration du rendement attendu, des contraintes sur la source de rayonnement ou le système de refroidissement...

Le procédé de paramétrage est de préférence mis en œuvre par un ordinateur. Il peut être considéré comme une étape préliminaire du procédé de traitement par balayage. Le jeu de paramètres déterminé au cours de cette étape préliminaire est ensuite appliqué lors de l'étape suivante d'exposition au rayonnement électromagnétique.

Dans un premier mode de mise en œuvre illustré par la figure 8, le procédé de paramétrage comprend des étapes S21 à S23 identiques aux étapes S11 à S13 du procédé de détermination illustré par la figure 5. Pour rappel, ces étapes consistent respectivement à acquérir une valeur pour chacun des paramètres E, L et V (au moins) du procédé de traitement, acquérir une valeur de l'épaisseur e de l'empilement et calculer la température d'échauffement T à partir des valeurs de paramètre acquises, grâce à l'équation [Math. 3].

L'étape d'acquisition S21 du procédé de paramétrage comprend avantageusement les opérations suivantes :

- la détermination d'une densité surfacique d'énergie Q à fournir à l'empilement 10' au moyen du rayonnement électromagnétique 20, afin d'obtenir l'amélioration du rendement souhaitée ;
- la détermination d'une vitesse de déplacement V, en fonction du temps de traitement souhaité et des dimensions de l'empilement 10' ; et
- le dimensionnement de la source de rayonnement 40, autrement dit la détermination d'une irradiance E du rayonnement électromagnétique 20 et d'une largeur L de la ligne 50 qui soient compatibles avec la densité surfacique d'énergie Q et la vitesse de déplacement V déterminées précédemment (c'est-à-dire qui vérifient la relation [Math. 1]).

Lorsque les valeurs de largeur L et d'irradiance E déterminées lors de la dernière opération ne sont compatibles avec aucune source de rayonnement, la vitesse de balayage V est réduite puis de nouvelles valeurs d'irradiance E et de largeur L sont déterminées (autrement dit, les deux dernières opérations sont répétées).

Comme décrit précédemment, la température initiale $T_0$, les températures $T_r$, $T_c$ relatives à l'environnement et le coefficient de convection h peuvent être également acquises lors de l'étape S21.

Le procédé de paramétrage selon la figure 8 comprend ensuite une étape S24 de comparaison de la température d'échauffement T (calculée à l'étape S23) avec la température limite $T_{max}$, qui peut avoir été prédéfinie ou acquise lors d'une étape préalable du procédé de paramétrage.

Les étapes suivantes S25 et S26 du procédé de paramétrage ne sont accomplies que lorsque la température d'échauffement T est strictement supérieure à la température limite $T_{max}$. A l'étape 25, au moins un paramètre d'ajustement est choisi parmi les paramètres du procédé de traitement. Puis, la valeur du paramètre d'ajustement est modifiée dans le sens d'une diminution de la température d'échauffement T lors de l'étape S26. A l'issue de l'étape S26, le procédé de paramétrage retourne à l'étape S23 pour effectuer un nouveau calcul de la température d'échauffement T, compte tenu de la valeur modifiée du paramètre d'ajustement.

Les étapes S23 à S26 du procédé de paramétrage sont ainsi répétées en boucle tant que la température d'échauffement T calculée à l'étape S23 est strictement supérieure à la température limite $T_{max}$.

Lorsqu'au contraire la température d'échauffement T est inférieure ou égale à la température limite $T_{max}$, le procédé de traitement par balayage peut être considéré comme paramétré, car l'ensemble de paramètres déterminé satisfait à la condition de température $T \leq T_{max}$.

A l'issue du procédé de paramétrage, un ou plusieurs paramètres peuvent être optimisés de manière empirique ou à l'aide de simulations thermiques.

Le procédé de paramétrage selon la figure 6 est avantageusement accompli lorsqu'un utilisateur, par exemple un fabricant de cellules photovoltaïques à hétérojonction, souhaite mettre en œuvre pour la première fois le procédé de traitement par balayage (autrement dit, à la conception du procédé de traitement).

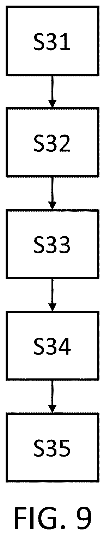

Dans un deuxième mode de mise en œuvre illustré par la figure 9, le procédé de paramétrage comprend :

- une étape S31 d'acquisition d'une valeur pour chacun des paramètres E, V et L (au moins) du procédé de traitement ;
- une étape S32 d'acquisition d'une valeur d'épaisseur e de l'empilement 10' ;
- une étape S33 consistant à recueillir une modification de valeur d'au moins un paramètre du procédé de traitement et/ou de l'épaisseur e de l'empilement 10' ;
- une étape S34 consistant à sélectionner un paramètre d'ajustement parmi les autres paramètres du procédé de traitement ; et
- une étape S35 de calcul d'une (nouvelle) valeur du paramètre d'ajustement telle que la température d'échauffement T de l'empilement soit inférieure ou égale à la température limite $T_{max}$, la valeur du paramètre d'ajustement étant calculée à partir des valeurs (modifiées et non-modifiées) des autres paramètres grâce à l'équation [Math. 3].

Le procédé de paramétrage selon la figure 9 permet de recalibrer un procédé de traitement existant, après qu'un ou plusieurs paramètres aient été modifiés (de manière intentionnelle ou non). Une telle modification peut intervenir dans de nombreuses situations. On peut citer à titre d'exemple le traitement d'un empilement 10' (ou lot d'empilements) d'épaisseur différente, un changement de source de rayonnement 40 consécutif à une panne, une dérive des paramètres du procédé de traitement, une augmentation de la température ambiante et donc de la température initiale $T_0$ de l'empilement 10'...

A l'étape S33, la valeur modifiée du (ou des) paramètre(s) peut être saisie par l'opérateur ou mesurée par un capteur (capteur de température, mesure optique d'épaisseur ou mesure de masse de l'empilement...)

L'étape S34 de sélection du paramètre d'ajustement peut être accomplie avant l'étape S33 de réception du paramètre modifié.

L'étape S35 de calcul de la valeur du paramètre d'ajustement peut être déclenchée par la réception du paramètre modifié (étape S33) et la valeur calculée peut être automatiquement appliquée lors de l'étape d'exposition qui suit, de sorte que le recalibrage du procédé de traitement par balayage s'effectue de manière autonome.

Enfin, le procédé de paramétrage selon la figure 9 peut comprendre en outre une étape de mesure de la température d'échauffement T au cours de l'étape d'exposition afin de contrôler et/ou d'améliorer l'ajustement du procédé de traitement.

Dans les premier et deuxième modes de mise en œuvre, le procédé de paramétrage comprend la définition d'un paramètre d'ajustement (étape S25 et S34) afin de retrouver une température d'échauffement T inférieure à la température limite $T_{max}$.

Dans certains cas, par exemple lorsqu'un système de refroidissement de l'empilement peut être ajouté ou optimisé, le paramètre d'ajustement peut être choisi parmi la température initiale $T_0$ de l'empilement, les températures $T_r$, $T_c$ relatives à l'environnement et le coefficient de convection h. Par exemple, on cherchera à réduire la température initiale $T_0$ de l'empilement, augmenter les échanges par convection (augmentation du coefficient h), à réduire la température $T_c$ du fluide qui entoure l'empilement (par exemple, avec un système de convection forcée par ventilation), augmenter les échanges par rayonnement en réduisant la température $T_r$ de l'enceinte. Ce choix évite de réduire la densité surfacique d'énergie Q dont dépend (jusqu'à une certaine valeur) l'amélioration du rendement.

Dans d'autres cas, le paramètre d'ajustement peut être choisi parmi l'irradiance E, la vitesse de balayage V et la largeur L, ce qui aura pour conséquence de diminuer la densité surfacique d'énergie Q (relation [Math. 1]). Lorsque la densité surfacique d'énergie Q a été choisie supérieure à la densité surfacique d'énergie $Q_{min}$ minimale pour obtenir le gain de rendement souhaité (par exemple +0,3 % absolu), un tel choix n'est pas préjudiciable (jusqu'à une certaine limite d'ajustement).

D'une manière générale (mais surtout lorsque la densité surfacique d'énergie Q visée est égale à la densité surfacique d'énergie minimale $Q_{min}$), il est préférable d'agir sur la température initiale $T_0$ ou les paramètres relatifs aux échanges de chaleur avec l'environnement ($T_r$, $T_c$ et h), typiquement par le biais d'un système de refroidissement.

Plusieurs paramètres du procédé de traitement peuvent être définis comme paramètres d'ajustement à l'étape S25 du procédé selon la figure 8 ou à l'étape S34 du procédé selon la figure 9. Par ailleurs, l'ajustement de certains paramètres peut être limité par les équipements qui composent le système de traitement par balayage (support 30, source de rayonnement 40, système de refroidissement...). Il peut être alors utile de définir un paramètre d'ajustement principal et des paramètres d'ajustement secondaires qui ne sont modifiés uniquement lorsque le paramètre d'ajustement principal a atteint sa limite.

Dans le procédé de paramétrage, et plus particulièrement à l'étape de comparaison S24 du procédé selon la figure 8 ou à l'étape de calcul S35 du procédé selon la figure 9, il est possible de considérer une température seuil (c.-à-d. à ne pas dépasser lors de l'étape d'exposition) autre que la température limite $T_{max}$ (température de dégradation du silicium amorphe). Cette température seuil est inférieure à la température limite $T_{max}$ (et supérieure à la température initiale $T_0$ de l'empilement). Le procédé de paramétrage comporte alors avantageusement une étape supplémentaire d'acquisition de cette température seuil (avant ladite étape de comparaison S24 ou étape de calcul S35).

Deux exemples de mise en œuvre du procédé de paramétrage vont maintenant être décrits. Le premier exemple concerne le procédé de paramétrage selon la figure 8 (procédé de conception) et le deuxième concerne le procédé de paramétrage selon la figure 9 (procédé de recalibration).

Exemple 1 :

Des expériences ont montré qu'un effet de bonification du rendement peut être obtenu pour une densité surfacique d'énergie $Q_{min}$ = 60 kJ/m$^2$.

On souhaite traiter des empilements de format pseudo-carré « M2 » (156,75 mm x 156,75 mm, diamètre 210 mm) en un temps inférieur ou égal à 5 s. Pour cela, la vitesse de balayage est fixée à V = 3,2 cm/s.

Afin de réaliser le traitement, on choisit une source de rayonnement permettant de générer une ligne de largeur L = 6 mm avec une irradiance E = 320 kW/m$^2$, ce qui vérifie l'équation [Math. 1].

Les empilements ont une épaisseur e = 160 $\mu$m (donnée fournisseur saisie manuellement, éventuellement vérifiée en entrée de ligne par une mesure de masse).

Le traitement s'effectuant en continu sur des empilements défilant sous la source de rayonnement et sans refroidissement, les températures $T_0$, $T_c$, $T_r$ sont estimées égales à 50 °C (échauffement de l'environnement lié au fonctionnement de la source), avec h = 10 W.m$^{-2}$.K$^{-1}$ (ordre de grandeur pour un régime de convection naturelle).

Le modèle analytique permet alors d'estimer que les empilements atteindront une température d'échauffement T égale à 231 °C. En considérant une température seuil de 200 °C (égale à $T_{max}$), il est décidé de refroidir l'environnement de traitement. En supposant que les températures $T_0$, $T_c$, $T_r$ sont égales, l'équation [Math. 3] indique que des températures $T_0$, $T_c$, $T_r$ inférieures ou égales à 18 °C sont nécessaires pour que la température d'échauffement T ne dépasse pas 200 °C.

Exemple 2 :

On considère comme référence le procédé de traitement suivant : Q = 52,3 kJ/m$^2$, E = 216 kW/m$^2$, V = 2,48 cm/s, L = 6 mm, e =160 $\mu$m ; $T_0$ = 25 °C et $\Phi_{ext}$ = 0.

Le modèle analytique (sans le terme $\phi_{ext}$) prédit une température de 184 °C. La température seuil est fixée à 200 °C.

On suppose qu'une nouvelle série d'empilements doit être traitée, avec une épaisseur de 120 $\mu$m. Le modèle analytique prédit alors une température de 238 °C. Il est choisi d'adapter la vitesse de balayage V afin de conserver une température acceptable. La résolution numérique de l'équation [Math. 3] indique que la vitesse de balayage V permettant d'obtenir une température de 200 °C est de 3,05 cm/s. Afin de tenir compte de l'erreur du modèle (les simulations thermiques prédisent une température initiale de 197 °C, au lieu de 184 °C), une vitesse sensiblement supérieure pourra être choisie comme point de départ pour un ajustement empirique. L'augmentation de la vitesse de balayage V implique une réduction de la densité surfacique d'énergie Q.

De nombreuses variantes et modifications du procédé de traitement par balayage, du procédé de détermination de la température d'échauffement T et du procédé de paramétrage apparaîtront à l'homme du métier.

Par exemple, le faisceau d'ondes électromagnétiques émis par la source de rayonnement 40 peut ne pas être orienté perpendiculairement à la surface de l'empilement 10'. En l'inclinant par rapport à la normale de la face de l'empilement, d'un angle inférieur à 90° (en valeur absolue), il est possible de faire varier la surface irradiée par le faisceau ainsi que la densité de puissance reçue par unité de surface. L'inclinaison peut être constante au cours du procédé de traitement ou être modulée au moyen d'une rotation de la source de rayonnement, par exemple de façon à réduire la densité surfacique d'énergie reçue par l'empilement en fin de balayage (c.-à-d. à l'approche de bord de fuite 100b) et à limiter encore davantage la surchauffe.

La ligne 50 peut être orientée d'un angle différent de 90° par rapport à la médiane M (cf. Fig.3). Elle peut également comprendre plusieurs segments de droite. Ces segments de droite peuvent être connectés, formant ainsi une ligne brisée, ou au contraire être disjoints. Les rayons du faisceau sont alors contenus dans plusieurs plans (sécants ou non). Les équations du modèle pourront être alors adaptées pour tenir compte de l'orientation et/ou du nombre de segments de droite.

Le procédé de traitement est applicable à un empilement 10' comprenant un substrat 11 en silicium cristallin dopé de type p (plutôt qu'en silicium cristallin dopé de type n).

Il peut être appliqué également à une cellule photovoltaïque à hétérojonction au sein d'un module photovoltaïque, notamment si la vitesse de balayage est suffisamment grande pour que la diffusion de chaleur dans le matériau d'encapsulation et les plaques de support (typiquement en verre) puisse être négligée.

Enfin, le modèle analytique peut être affiné (ou enrichi) afin d'améliorer la précision des résultats, par exemple :

- en établissant d'autres expressions pour les termes $\Delta T_c$, $L_{c1}$, $L_{c2}$, $\Phi_{source}$ et $\Phi_{ext}$ du modèle, en particulier en ajoutant à la quantité de chaleur $\Phi_{ext}$ un terme lié au système de refroidissement, en considérant la même échelle de longueur (L+$\delta$) pour les termes convectif et diffusif du modèle, en négligeant la couche limite thermique ($\delta$ = 0) (notamment pour les fortes vitesses de balayage)... ;
- de manière empirique en se basant sur des résultats numériques ou expérimentaux ; et/ou
- en utilisant des méthodes d'apprentissage par machine avec des données expérimentales ou obtenus par simulation.

**Revendications**

1. Procédé de paramétrage d'un procédé de traitement d'un empilement (10') obtenu lors de la fabrication d'une cellule photovoltaïque à hétérojonction, l'empilement (10') comprenant un substrat (11) en silicium cristallin et une couche de passivation (14) en silicium amorphe hydrogéné disposée sur le substrat, le procédé de traitement visant à améliorer le rendement de la cellule photovoltaïque à hétérojonction et comprenant une étape d'exposition d'une face de l'empilement (10') à un rayonnement électromagnétique (20), le rayonnement électromagnétique (20) étant émis par une source de rayonnement (40) et appliqué à la face de l'empilement (10') selon une ligne (50), l'empilement (10') et la source de rayonnement (40) étant animés d'un mouvement relatif de translation tel que la ligne (50) balaye une partie au moins de la face de l'empilement (10'), le procédé de paramétrage comprenant la détermination d'une pluralité de paramètres du procédé de traitement de sorte que la température d'échauffement (T) de l'empilement (10') atteinte lors du procédé de traitement soit inférieure ou égale à une température seuil ($T_{max}$), la pluralité de paramètres comprenant une irradiance (E) du rayonnement électromagnétique (20), une largeur (L) de la ligne (50) et une vitesse (V) de déplacement relatif entre l'empilement (10') et la source de rayonnement (40) et étant déterminée en utilisant la relation suivante :

$$V\rho c_p \frac{\Delta T_c(T)}{L_{c1}(L)} = -k\frac{\Delta T_c(T)}{\left(L_{c2}(L)\right)^2} + \phi_{source}(E,e) + \phi_{ext}$$

dans laquelle :

- V est la vitesse de déplacement relatif entre l'empilement (10') et la source de rayonnement (40) ;
- $\Delta T_c$ est fonction de la température d'échauffement (T) et représente une variation de température caractéristique de l'échauffement (10') dans une direction perpendiculaire à la ligne (50) ;
- $L_{c1}$ est fonction de la largeur (L) de la ligne (50) et représente une première longueur caractéristique de la convection de chaleur lors du déplacement relatif entre l'empilement (10') et la source de rayonnement (40) ;
- $L_{c2}$ est fonction de la largeur (L) de la ligne (50) et représente une deuxième longueur caractéristique de la diffusion de chaleur dans une direction perpendiculaire à la ligne ;
- $\Phi_{source}$ est fonction de l'irradiance (E) du rayonnement électromagnétique (20) et de l'épaisseur (e) de l'empilement (10') et représente la quantité de chaleur par unité de volume apportée par la source de rayonnement (40) ;
- $\Phi_{ext}$ représente la quantité de chaleur par unité de volume échangée avec un environnement extérieur, dans lequel est placé l'empilement (10') lors de l'étape d'exposition au rayonnement électromagnétique (20) ;
- $\rho$, $c_p$ et k sont respectivement la masse volumique, la capacité massique et la conductivité thermique de l'empilement (10').

2. Procédé de paramétrage selon la revendication 1, comprenant les étapes suivantes :

a) acquérir une valeur pour chacun des paramètres du procédé de traitement ;
b) acquérir une valeur d'épaisseur (e) de l'empilement (10') ;
c) calculer une température d'échauffement (T) de l'empilement en utilisant ladite relation ;
d) comparer la température d'échauffement (T) calculée à une température seuil ($T_{max}$) ; et

tant que la température d'échauffement (T) calculée est strictement supérieure à la température seuil ($T_{max}$), les étapes suivantes :

e) choisir un paramètre d'ajustement parmi les paramètres du procédé de traitement ;
f) modifier la valeur du paramètre d'ajustement ; et
g) répéter les étapes c) et d).

3. Procédé de paramétrage selon la revendication 1, comprenant les étapes suivantes :

- acquérir une valeur pour chacun des paramètres du procédé de traitement ;
- acquérir une valeur d'épaisseur (e) de l'empilement (10') ;
- recueillir une modification de valeur d'au moins un paramètre du procédé de traitement et/ou de l'épaisseur (e) de l'empilement (10') ;
- sélectionner un paramètre d'ajustement parmi les autres paramètres du procédé de traitement ;
- déterminer une valeur du paramètre d'ajustement telle que la température d'échauffement (T) soit inférieure ou égale à la température seuil ($T_{max}$), la valeur du paramètre d'ajustement étant déterminée en utilisant ladite relation.

4. Procédé de paramétrage selon l'une des revendications 2 et 3, dans lequel la pluralité de paramètres comprend en outre une pluralité de températures ($T_r$, $T_c$) relatives à l'environnement extérieur et un coefficient d'échange par convection (h) et dans lequel le paramètre d'ajustement est choisi parmi lesdites températures et ledit coefficient.

5. Procédé de paramétrage selon l'une des revendications 2 et 3, dans lequel le paramètre d'ajustement est choisi parmi l'irradiance (E) du rayonnement électromagnétique (20), la largeur (L) de la ligne (50) et la vitesse (V) de déplacement relatif entre l'empilement (10') et la source de rayonnement (40).

6. Procédé de traitement d'un empilement (10') obtenu lors de la fabrication d'une cellule photovoltaïque à hétérojonction, l'empilement (10') comprenant un substrat (11) en silicium cristallin et une couche de passivation (14) en silicium amorphe hydrogéné disposée sur le substrat (11), le procédé de traitement visant à améliorer le rendement de la cellule photovoltaïque à hétérojonction et comprenant une étape d'exposition d'une face de l'empilement (10') à un rayonnement électromagnétique (20) émis par une source de rayonnement (40), le rayonnement électromagnétique (20) étant appliqué à la face de l'empilement (10') selon une ligne (50), l'empilement (10') et la source de rayonnement (40) étant animés d'un mouvement relatif de translation tel que la ligne (50) balaye une partie au moins de la face de l'empilement (10'), le procédé de traitement comprenant en outre une étape préalable de détermination d'une pluralité de paramètres à appliquer lors de l'étape d'exposition, la pluralité de paramètres étant déterminée selon la revendication 1.

7. Procédé selon l'une quelconque des revendications 1 à 6, dans lequel la température seuil ($T_{max}$) est inférieure ou égale à une température de dégradation du silicium amorphe.

8. Dispositif de traitement de données comprenant des moyens de mettre en œuvre un procédé selon l'une quelconque des revendications 1 à 5.

9. Produit programme d'ordinateur comprenant des instructions qui, lorsque le programme est exécuté par un ordinateur, conduisent celui-ci à mettre en œuvre un procédé selon l'une quelconque des revendications 1 à 5.

10. Support de données lisible par ordinateur, sur lequel est enregistré le produit programme d'ordinateur selon la revendication 9.

**Patentansprüche**

1. Verfahren zum Parametrieren eines Behandlungsverfahrens eines Stapels (10'), der bei der Herstellung einer Heteroübergangs-Photovoltaikzelle erhalten wird, wobei der Stapel (10') ein Substrat (11) aus kristallinem Silizium und eine Passivierungsschicht (14) aus hydriertem amorphen Silizium umfasst, die auf dem Substrat angeordnet ist, wobei das Behandlungsverfahren eine Verbesserung des Wirkungsgrads der Heteroübergangs-Photovoltaikzelle anstrebt und einen Schritt umfasst, bei dem eine Seite des Stapels (10') einer elektromagnetischen Strahlung (20) ausgesetzt wird, wobei die elektromagnetische Strahlung (20) von einer Strahlungsquelle (40) emittiert und entlang einer Linie (50) auf die Seite des Stapels (10') aufgebracht wird, wobei der Stapel (10') und die Strahlungsquelle (40) in eine relative Translationsbewegung versetzt werden, so dass die Linie (50) mindestens einen Teil der Fläche des Stapels (10') überstreicht, wobei das Parametrierungsverfahren die Bestimmung einer Vielzahl von Parametern des Behandlungsverfahrens umfasst, so dass die Erwärmungstemperatur (T) des Stapels (10'), die während des Behandlungsverfahrens erreicht wird, kleiner oder gleich einer Schwellentemperatur ($T_{max}$) ist, wobei die Vielzahl von Parametern eine Bestrahlungsstärke (E) der elektromagnetischen Strahlung (20), eine Breite (L) der Linie (50) und eine Geschwindigkeit (V) der relativen Bewegung zwischen dem Stapel (10') und der Strahlungsquelle (40) umfasst und unter Verwendung der folgenden Relation bestimmt wird:

$$V\rho c_P \frac{\Delta T_C(T)}{L_{C1}(L)} = -k\, \frac{\Delta T_C(T)}{\left(L_{C2}(L)\right)^2} + \emptyset_{source}(E, e) + \emptyset_{ext}$$

in der:

- V die Geschwindigkeit der relativen Bewegung zwischen dem Stapel (10') und der Strahlungsquelle (40) ist;
- $\Delta T_c$ eine Funktion der Erwärmungstemperatur (T) ist und eine charakteristische Temperaturänderung der Erwärmung (10') in einer Richtung senkrecht zur Linie (50) darstellt;
- $L_{c1}$ eine Funktion der Breite (L) der Linie (50) ist und eine erste Länge darstellt, die für die Wärmekonvektion bei der Relativbewegung zwischen dem Stapel (10') und der Strahlungsquelle (40) charakteristisch ist;
- $L_{c2}$ eine Funktion der Breite (L) der Linie (50) ist und eine zweite charakteristische Länge der Wärmediffusion in einer Richtung senkrecht zur Linie darstellt;
- $\emptyset_{Quelle}$ eine Funktion der Bestrahlungsstärke (E) der elektromagnetischen Strahlung (20) und der Dicke (e) des Stapels (10') ist und die Wärmemenge pro Volumeneinheit darstellt, die von der Strahlungsquelle (40) eingebracht wird;
- $\emptyset_{ext}$ die Wärmemenge pro Volumeneinheit darstellt, die mit einer äußeren Umgebung ausgetauscht wird, in der der Stapel (10') während des Schritts der Exposition gegenüber der elektromagnetischen Strahlung (20) angeordnet ist;

- $\rho$, $C_p$ und k jeweils die Dichte, die Massenkapazität und die Wärmeleitfähigkeit des Stapels (10') sind.

2. Parametrierungsverfahren nach Anspruch 1, **dadurch gekennzeichnet, dass** es folgende zusätzliche Schritte umfasst:

    a) Erfassen eines Wertes für jeden der Parameter des Behandlungsverfahrens;
    b) Erfassen eines Wertes für die Dicke (e) des Stapels (10');
    c) Berechnen einer Erwärmungstemperatur (T) des Stapels unter Verwendung der genannten Beziehung;
    d) Vergleichen der berechneten Erwärmungstemperatur (T) mit einer Schwellentemperatur ($T_{max}$); und

solange die berechnete Erwärmungstemperatur (T) strikt über der Schwellentemperatur ($T_{max}$) liegt, die folgenden Schritte:

    e) Auswählen eines Anpassungsparameters aus den Parametern des Behandlungsverfahrens;
    f) Ändern des Werts des Anpassungsparameters; und
    g) Wiederholen der Schritte c) und d).

3. Parametrierungsverfahren nach Anspruch 1, **dadurch gekennzeichnet, dass** es folgende zusätzliche Schritte umfasst:

    - Erfassen eines Wertes für jeden der Parameter des Behandlungsverfahrens;
    - Erfassen eines Wertes für die Dicke (e) des Stapels (10');
    - Protokollieren einer Änderung des Wertes mindestens eines Parameters des Behandlungsverfahrens und/oder der Dicke (e) des Stapels (10');
    - Auswählen eines Anpassungsparameters aus den anderen Parametern des Behandlungsverfahrens;
    - Bestimmen eines Wertes des Anpassungsparameters derart, dass die Erwärmungstemperatur (T) niedriger oder gleich der Schwellentemperatur ($T_{max}$) ist, wobei der Wert des Anpassungsparameters unter Verwendung der genannten Beziehung bestimmt wird.

4. Parametrierungsverfahren nach einem der Ansprüche 2 und 3, in dem die Vielzahl von Parametern zusätzlich eine Vielzahl von Temperaturen ($T_r$, $T_c$) bezüglich der äußeren Umgebung und einen Konvektionsaustauschkoeffizienten (h) umfasst und in dem der Anpassungsparameter aus den Temperaturen und dem Koeffizienten ausgewählt wird.

5. Parametrierungsverfahren nach einem der Ansprüche 2 und 3, in dem der Anpassungsparameter aus der Bestrahlungsstärke (E) der elektromagnetischen Strahlung (20), der Breite (L) der Linie (50) und der Geschwindigkeit (V) der relativen Bewegung zwischen dem Stapel (10') und der Strahlungsquelle (40) ausgewählt wird.

6. Verfahren zur Behandlung eines Stapels (10'), der bei der Herstellung einer Heteroübergangs-Photovoltaikzelle erhalten wird, wobei der Stapel (10') ein Substrat (11) aus kristallinem Silizium und eine Passivierungsschicht (14) aus hydriertem amorphen Silizium umfasst, die auf dem Substrat (11) angeordnet ist, wobei das Behandlungsverfahren darauf abzielt, den Wirkungsgrad der Heteroübergangs-Photovoltaikzelle zu verbessern und einen Schritt umfasst, bei dem eine Seite des Stapels (10') einer elektromagnetischen Strahlung (20) ausgesetzt wird, die von einer Strahlungsquelle (40) emittiert wird, die elektromagnetische Strahlung (20) auf die Seite des Stapels (10') entlang einer Linie (50) aufgebracht wird, wobei der Stapel (10') und die Strahlungsquelle (40) in eine relative Translationsbewegung versetzt werden, so dass die Linie (50) mindestens einen Teil der Seite des Stapels (10') überstreicht, wobei das Behandlungsverfahren außerdem einen vorherigen Schritt zur Bestimmung einer Vielzahl von Parametern umfasst, die beim Expositionsschritt angewendet werden sollen, wobei die Vielzahl von Parametern gemäß Anspruch 1 bestimmt wird.

7. Verfahren nach einem der Ansprüche 1 bis 6, in dem die Schwellentemperatur ($T_{max}$) niedriger oder gleich einer Abbautemperatur des amorphen Siliziums ist.

8. Datenverarbeitungsvorrichtung mit Mitteln zur Durchführung eines Verfahrens nach einem der Ansprüche 1 bis 5.

9. Computerprogrammprodukt mit Anweisungen, die, wenn das Programm von einem Computer ausgeführt wird, diesen dazu veranlassen, ein Verfahren nach einem der Ansprüche 1 bis 5 auszuführen.

10. Computerlesbarer Datenträger, auf dem das Computerprogrammprodukt nach Anspruch 9 gespeichert ist.

**Claims**

1. Method for setting parameters of a method for treating a stack (10') obtained upon manufacturing a heterojunction photovoltaic cell, the stack (10') comprising a crystalline silicon substrate (11) and a hydrogenated amorphous silicon passivation layer (14) disposed on the substrate, the treatment method aiming to improve efficiency of the heterojunction photovoltaic cell and comprising a step of exposing a face of the stack (10') to electromagnetic radiation (20), the electromagnetic radiation (20) being emitted by a radiation source (40) and applied to the face of the stack (10') along a line (50), the stack (10') and the radiation source (40) being relatively translationally moving such that the line (50) sweeps at least part of the face of the stack (10'), the method for setting parameters comprising determining a plurality of parameters of the treatment method so that the heat-up temperature (T) of the stack (10') reached during the treatment method is less than or equal to a threshold temperature ($T_{max}$), the plurality of parameters comprising an irradiance (E) of the electromagnetic radiation (20), a width (L) of the line (50) and a speed (V) of relative displacement between the stack (10') and the radiation source (40) and being determined using the following relationship:

$$V \rho c_P \frac{\Delta T_C(T)}{L_{C1}(L)} = -k \frac{\Delta T_C(T)}{\left(L_{C2}(L)\right)^2} + \emptyset_{source}(E, e) + \emptyset_{ext}$$

wherein:

- V is the speed of relative displacement between the stack (10') and the radiation source (40);
- $\Delta T_c$ is a function of heat-up temperature (T) and represents a temperature variation characteristic of the heat-up (10') in a direction perpendicular to the line (50);
- $L_{c1}$ is a function of width (L) of the line (50) and represents a first length characteristic of heat convection during the relative displacement between the stack (10') and the radiation source (40);
- $L_{c2}$ is a function of width (L) of the line (50) and represents a second length characteristic of heat diffusion in a direction perpendicular to the line;
- $\emptyset_{source}$ is a function of irradiance (E) of the electromagnetic radiation (20) and thickness (e) of the stack (10') and represents the quantity of heat per unit volume supplied by the radiation source (40);
- $\emptyset_{ext}$ represents the quantity of heat per unit volume exchanged with an external environment in which the stack (10') is placed during the step of exposing to the electromagnetic radiation (20);
- $\rho$, $C_p$ and k are respectively the density, specific heat capacity and thermal conductivity of the stack (10').

2. Method for setting parameters according to claim 1, comprising the following steps of:

   a) acquiring a value for each of the parameters of the treatment method;
   b) acquiring a thickness value (e) for the stack (10');
   c) calculating a heat-up temperature (T) of the stack using said relationship;
   d) comparing the heat-up temperature (T) calculated with a threshold temperature ($T_{max}$); and

   as long as the heat-up temperature (T) calculated is strictly greater than the threshold temperature ($T_{max}$), the following steps of:

   e) selecting an adjustment parameter from the parameters of the treatment method;
   f) changing value of the adjustment parameter; and
   g) repeating steps c) and d).

3. Method for setting parameters according to claim 1, comprising the following steps of:

   - acquiring a value for each of the parameters of the treatment method;
   - acquiring a thickness value (e) for the stack (10');
   - collecting a change in the value of at least one parameter of the treatment method and/or the thickness (e) of the stack (10');
   - selecting an adjustment parameter from the other parameters of the processing method;
   - determining a value of the adjustment parameter such that the heat-up temperature (T) is less than or equal to the threshold temperature ($T_{max}$), the value of the adjustment parameter being determined using said relationship.

4. Method for setting parameters according to one of claims 2 and 3, wherein the plurality of parameters further comprises a plurality of temperatures ($T_r$, $T_c$) relative to the external environment and a convective heat exchange coefficient (h) and wherein the adjustment parameter is selected from said temperatures and said coefficient.

5. Method for setting parameters according to one of claims 2 and 3, wherein the adjustment parameter is selected from irradiance (E) of the electromagnetic radiation (20), width (L) of the line (50) and speed (V) of relative displacement between the stack (10') and the radiation source (40).

6. Method for treating a stack (10') obtained upon manufacturing a heterojunction photovoltaic cell, the stack (10') comprising a crystalline silicon substrate (11) and a hydrogenated amorphous silicon passivation layer (14) disposed on the substrate (11), the treatment method aiming to improve efficiency of the heterojunction photovoltaic cell and comprising a step of exposing a face of the stack (10') to electromagnetic radiation (20) emitted by a radiation source (40), the electromagnetic radiation (20) being applied to the face of the stack (10') along a line (50), the stack (10') and the radiation source (40) being relatively translationally moving such that the line (50) sweeps at least part of the face of the stack (10'), the treatment method further comprising a prior step of determining a plurality of parameters to be applied during the exposure step, the plurality of parameters being determined according to claim 1.

7. Method according to any of claims 1 to 6, wherein the threshold temperature ($T_{max}$) is less than or equal to an amorphous silicon degradation temperature.

8. Data processing device comprising means for implementing a method according to any of claims 1 to 5.

9. Computer program product comprising instructions which, when the program is executed by a computer, cause the same to implement a method according to any of claims 1 to 5.

10. Computer-readable data medium, having the computer program product according to claim 9 recorded thereon.

FIG. 1

FIG. 2

FIG. 3

FIG. 4

FIG. 5

FIG. 6

FIG. 7

FIG. 8

FIG. 9

RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2013001440 A
- CN 107546296 A

- WO 2020082131 A1